# EUROPÄISCHE PATENTSCHRIFT

(11) **EP 3 491 468 B1**
(45) Veröffentlichungstag und Bekanntmachung des Hinweises auf die Patenterteilung: **21.02.2024**
(21) Anmeldenummer: 17740385.4
(22) Anmeldetag: 17.07.2017
(51) Int. Cl.: G03F 7/20, G21K 1/06

(54) **REFLEKTIVES OPTISCHES ELEMENT FÜR DIE EUV-LITHOGRAPHIE**
REFLECTIVE OPTICAL ELEMENT FOR EUV LITHOGRAPHY
ÉLÉMENT OPTIQUE RÉFLÉCHISSANT DESTINÉ À LA LITHOGRAPHIE EUV

(30) Priorität: 27.07.2016 DE 102016213831
(43) Veröffentlichungstag der Anmeldung: 05.06.2019
(73) Patentinhaber: Carl Zeiss SMT GmbH, 73447 Oberkochen (DE)
(72) Erfinder: EHM, Dirk Heinrich, 66701 Beckingen (DE); SHKLOVER, Vitaliy, 89522 Heidenheim (DE); AMENT, Irene, 73434 Aalen (DE); SCHMIDT, Stefan-Wolfgang, 73431 Aalen (DE); BECKER, Moritz, 73430 Aalen (DE); WIESNER, Stefan, 73466 Lauchheim (DE); URICH, Diana, 80801 München (DE); MEIER, Robert, 81667 München (DE); WINTER, Ralf, 73529 Schwäbisch Gmünd (DE); JALICS, Christof, 89522 Heidenheim (DE); KIEREY, Holger, 73431 Aalen (DE); EVA, Eric, 73434 Aalen (DE)
(74) Vertreter: Werner & ten Brink
(86) Internationale Anmeldenummer: PCT/EP2017/068061
(87) Internationale Veröffentlichungsnummer: WO 2018/019645

(56) Entgegenhaltungen:
- WO-A1-2012/028613
- WO-A1-2017/123323
- DE-A1-102008 042 212
- DE-A1-102011 015 141
- DE-A1-102013 102 670
- DE-A1-102013 215 541
- US-A1- 2013 170 056
- "Research Disclosure", RESEARCH DISCLOSURE, KENNETH MASON PUBLICATIONS, HAMPSHIRE, UK, GB, Bd. 586, Nr. 33, 1. Februar 2013 (2013-02-01), Seite 136, XP007141917, ISSN: 0374-4353

## Beschreibung

Die vorliegende Erfindung bezieht sich auf ein reflektives optisches Element für die EUV-Lithographie, das ein Substrat und eine reflektiven Beschichtung zur Reflexion von Strahlung im Wellenlängenbereich von 5 nm bis 20 nm aufweist. Ferner bezieht sie sich auf ein optisches System für eine EUV-Lithographievorrichtung sowie auf eine EUV-Lithographievorrichtung mit einem solchen reflektiven optischen Element.

In EUV-Lithographievorrichtungen werden zur Lithographie von Halbleiterbauelementen reflektive optische Elemente für den extremen ultravioletten (EUV) Wellenlängenbereich (z.B. Wellenlängen zwischen ca. 5 nm und 20 nm) wie etwa Photomasken oder Spiegel auf der Basis von Viellagensystemen für quasi-normalen Einfall oder Spiegel mit metallischer Oberfläche für streifenden Einfall eingesetzt. Da EUV-Lithographievorrichtungen in der Regel mehrere reflektive optische Elemente aufweisen, müssen diese eine möglichst hohe Reflektivität aufweisen, um eine hinreichend hohe Gesamtreflektivität sicherzustellen. Die Reflektivität und die Lebensdauer der reflektiven optischen Elemente kann durch Kontamination der optisch genutzten reflektiven Fläche der reflektiven optischen Elemente, die aufgrund der kurzwelligen Bestrahlung zusammen mit Restgasen in der Betriebsatmosphäre entsteht, reduziert werden. Da üblicherweise in einer EUV-Lithographievorrichtung mehrere reflektive optische Elemente hintereinander angeordnet sind, wirken sich auch schon geringere Kontaminationen auf jedem einzelnen reflektiven optischen Element in größerem Maße auf die Gesamtreflektivität aus.

Kontamination kann beispielsweise aufgrund von hohen Wasserstoffpartialdrücken auftreten. Dabei werden Wassermoleküle durch die EUV-Strahlung aufgespalten und die resultierenden Sauerstoffradikale oxidieren die optisch aktiven Flächen der reflektiven optischen Elemente. Eine weitere Kontaminationsquelle sind Kohlenwasserstoffmoleküle, die beispielsweise aus den in EUV-Lithographievorrichtungen verwendeten Vakuumpumpen stammen können oder von Rückständen von Photolacken, die auf den zu strukturierenden Halbleitersubstraten verwendet werden, und die unter Einfluss der Betriebsstrahlung zu Kohlenstoffkontaminationen auf den reflektiven optischen Elementen führen. Bei Kollektorspiegeln, die in Verbindung mit einer Plasmalaserquelle im Einsatz sind, kommt als zusätzliche Kontaminationsquelle das Material, das zu einem Plasma angeregt wird, beispielsweise Zinn, hinzu. Während oxidative Kontaminationen in der Regel irreversibel sind, lassen sich insbesondere Kohlenstoffkontaminationen und ggf. Zinn u.a. durch Behandlung mit reaktivem Wasserstoff entfernen, indem der reaktive Wasserstoff damit zu flüchtigen Verbindungen reagiert. Bei reaktivem Wasserstoff kann es sich um Wasserstoffradikale oder auch ionisierte Wasserstoffatome oder -moleküle handeln.

Es ist allerdings beobachtet worden, dass es unter dem Einfluss von reaktivem Wasserstoff, der zur Reinigung verwendet wird oder der aufgrund der Wechselwirkung der EUV-Strahlung mit in der Restatmosphäre vorhandenem molekularen Wasserstoff entstehen kann, zur Blasenbildung und sogar zum Ablösen der reflektiven Beschichtung kommen kann. Die makroskopische Blasenbildung bzw. Delaminierung wird insbesondere bei Kollektorspiegeln beobachtet, die verglichen mit anderen reflektiven optischen Elementen einer EUV-Lithographievorrichtung in besonderem Maße reaktivem Wasserstoff ausgesetzt sind.

Die Delaminierung wird vermutlich durch das Eindringen von reaktivem Wasserstoff in die reflektive Beschichtung, insbesondere an mechanischen oder bei der Beschichtung aufgetretenen Defekten verursacht. Der eindiffundierte reaktive Wasserstoff kann zu molekularem Wasserstoff rekombinieren und so zu Blasenbildung und im schlimmsten Fall Aufbrechen bzw. Abblättern der reflektiven Beschichtung führen. Derartige Schadstellen weisen eine hohe Reflexion im infraroten Wellenlängenbereich auf. Dies ist insbesondere bei Kollektorspiegeln schädlich. Denn bei ihnen tritt die höchste Wärmelast auf, u.a. aufgrund der Infrarotlaser, die in der Strahlungsquelle eingesetzt sein können, und bei Reflexion der Wärmestrahlung in Richtung Strahlengang der EUV-Lithographievorrichtung können insbesondere die nachfolgenden reflektiven optischen Elemente geschädigt werden.

Ein Ansatz, gegen den wasserstoffbedingten Delaminationseffekt vorzugehen, besteht darin, auf der reflektiven Beschichtung ein Schutzschichtsystem gegen reaktiven Wasserstoff vorzusehen, wie beispielsweise in der WO 2014/139694 A1 vorgeschlagen.

Aus der DE 10 2008 042 212 A1 ist bekannt, zwischen Substrat und als Viellagensystem ausgebildeter reflektiver Beschichtung eine Molybdänschicht als spannungskompensierende Schicht vorzusehen.

In der DE 10 2011 015 141 A1 wird vorgeschlagen, auf der Oberfläche eines Substrat eine Strukturierungsschicht aus weichem Material wie u.a. Kupfer, Gold, Silber, Platin, Nickel-Phosphor vorzusehen, in die eine optisch wirksame Mikrostukturierung eingearbeitet ist, um bestimmte Wellenlängen aus der einfallenden Strahlung herauszufiltern.

Aus der WO 2012/028613 A1 ist ein Spiegel für eine EUV-Projektionsbelichtungsanlage, umfassend ein Substrat mit Haftvermittlerschicht zwischen Substrat und Polierschicht und darauf einer hochreflektierender Schicht bekannt.

Es ist eine Aufgabe der vorliegenden Erfindung, ein anderes reflektives optisches Element für die EUV-Lithographie vorzuschlagen, bei dem das Risiko eines Aufbrechens bzw. Abblätterns der reflektiven Beschichtung verringert ist.

Diese Aufgabe wird gelöst durch ein reflektives optisches Element für die EUV-Lithographie, das ein Substrat und eine reflektive Beschichtung zur Reflexion von Strahlung im Wellenlängenbereich von 5 nm bis 20 nm aufweist und bei dem zwischen der reflektiven Beschichtung und dem Substrat eine funktionale Schicht angeordnet ist, durch die die Konzentration von Wasserstoff in Atom-% an der der reflektiven Beschichtung zugewandten Seite des Substrats um mindestens einen Faktor 2 reduziert wird, wobei eine mikrostrukturierte Schicht zwischen der reflektiven Beschichtung und dem Substrat angeordnet ist und auf der funktionalen Schicht oder der mikrostrukturierte Schicht eine Polierschicht angeordnet ist und auf dem Substrat eine Haftvermittlerschicht angeordnet ist, die aus mindestens einer Lage besteht und ein oder mehrere Materialien der Gruppe aus Ruthenium, Chrom, Platin, Iridium, Kupfer, Silber, Gold, Nickel, Nickel-Phosphor, Tantal, Titan, Zirkonium, Wolfram, Molybdän und Niob aufweist.

Es hat sich herausgestellt, dass eine funktionale Schicht zwischen Substrat und reflektiver Beschichtung, die die Konzentration von Wasserstoff in Atom-% an der der reflektiven Beschichtung zugewandten Seite des Substrats um mindestens einen Faktor 2 reduziert, verglichen mit dem entsprechenden reflektiven optischen Element ohne diese funktionale Schicht, die Wahrscheinlichkeit des Aufbrechens oder Delaminierens der reflektiven Beschichtung als Ganzes reduzieren kann. Bevorzugt wird die Wasserstoffkonzentration um einen Faktor von mindestens 5, besonders bevorzugt von mindestens 10, ganz besonders bevorzugt von mindestens 50 und überaus besonders bevorzugt von mindestens 100 reduziert. Die funktionale Schicht wirkt quasi als eine Art Diffusionsbarriere für reaktiven Wasserstoff, so dass ein Rekombinieren von reaktivem zu molekularem Wasserstoff unterhalb der reflektiven Beschichtung unterdrückt wird.

insbesondere wird das Delaminierungsrisiko auch bei reflektiven optischen Elementen reduziert, die auf der reflektiven Beschichtung ein Schutzschichtsystem gegen reaktiven Wasserstoff aufweisen. Denn es hat sich gezeigt, dass insbesondere an Defekten im Schutzschichtsystem bzw. in der reflektiven Beschichtung reaktiver Wasserstoff so tief eindiffundieren kann, dass ein nicht vernachlässigbares Restrisiko eines Delaminierens des reflektiven Beschichtung vom Substrat bestehen bleibt. Dies kann aber durch die hier vorgeschlagene funktionale Schicht weiter reduziert werden.

Unter Beschichtung seien sowohl Beschichtungen auf Basis von Viellagensystemen verstanden, die besonders für den normalen und quasi-normalen Einfall geeignet sind und auf Bragg-Reflexion beruhen, als auch Beschichtungen mit nur einer oder wenigen Lagen, die für den streifenden Einfall geeignet sind und auf Totalreflexion beruhen. Es sei darauf hingewiesen, dass das reflektive optische Element mit einer funktionalen Schicht genau eine funktionale Schicht oder zwei oder drei oder mehr funktionale Schichten aufweisen kann.

Durch das Vorsehen der Haftvermittlerschicht kann die Haftung unterhalb der reflektiven Beschichtung erhöht werden und somit die Wahrscheinlichkeit eines Delaminierens der reflektiven Beschichtung zusätzlich verringert werden.

Auf der funktionalen Schicht oder der mikrostrukturierten Schicht ist eine Polierschicht angeordnet. Um gute Abbildungseigenschaften zu erreichen, ist es bei reflektiven optischen Elementen für die EUV-Lithographie von Vorteil, wenn die reflektive Beschichtung eine quadratische Rauheit (auch RMS-Rauheit) im Ortsfrequenzbereich von 0,1 µm bis 200 µm von nicht mehr als 0,5 nm, bevorzugt nicht mehr als 0,25 nm aufweist. Dazu sollte auch die Fläche, auf die die reflektive Beschichtung aufgebracht wird, eine vergleichbar geringe Rauheit aufweisen. Besonders bevorzugt weist die Polierschicht in diesem Ortsfrequenzbereich eine RMS-Rauheit von nicht mehr als 0,2 nm auf.

In bevorzugten Ausführungsformen weist die funktionale Schicht eines oder mehrere der Materialien der Gruppe Zinn, Silber, Molybdän, Ruthenium, Iridium, Nickel, Eisen, Kobalt, Kupfer, Aluminium, Platin, Zink, Mangan, Blei, Gold, Palladium, Wolfram, Tantal, deren Legierungen, deren Oxide, Boride, Nitride und Karbide auf. Besonders bevorzugt weist die funktionale Schicht Zinnoxid oder Zinnnitrid auf. Bei reflektiven optischen Elementen, die derartige funktionale Schichten aufweisen, kann seltener ein Aufbrechen oder Delaminieren der reflektiven Beschichtung als Ganzes beobachtet werden.

Die mikrostrukturierte Schicht dient dazu, Strahlung aus unerwünschten Wellenlängenbereichen wie etwa Infrarot oder Ultraviolett aus dem Strahlengang herauszulenken, um Fehlbelichtungen zu vermeiden, die Wärmelast auf den im Strahlengang folgenden reflektiven optischen Elementen zu verringern und sonstige Schäden in einer EUV-Lithographievorrichtung zu vermeiden. Dazu ist sie derart strukturiert, das die Strahlung aus unerwünschten Wellenlängenbereichen durch destruktive Interferenz unterdrückt werden kann. Beispielsweise kann sie als Beugungsgitter ausgebildet sein. Wenn die mikrostrukturierte Schicht als separate Schicht ausgebildet ist, lässt sie sich gezielter zum Zwecke der Spektralfilterung optimieren.

Bevorzugt weist die separate mikrostrukturierte Schicht in diesen anderen Varianten eines oder mehrere Materialien der Gruppe Nickel-Phosphor, Nickel-Bor, Kupfer, Silber, Gold, Platin, Iridium, Tantal, Titan, Zirkonium, Wolfram, Molybdän und Niob auf. Diese Materialien lassen sich in hinreichend großen Dicken von einigen hundert Mikrometern aufbringen und gut strukturieren.

Vorteilhafterweise ist die funktionale Schicht zwischen der reflektiven Beschichtung und der mikrostrukturierte Schicht angeordnet, um das Risiko eines Delaminierens der reflektiven Beschichtung nicht nur vom Substrat, sondern von der mikrostrukturierten Schicht zu reduzieren. Optional kann die funktionale Schicht auch oder zusätzlich zwischen Substrat und mikrostrukturierter Schicht angeordnet sein, um eine Delaminieren am Substrat möglichst zu vermeiden. Eine weitere alternative oder zusätzliche vorteilhafte Option besteht darin, die funktionale Schicht innerhalb der mikrostrukturierten Schicht vorzusehen.

Besonders geeignet als Polierschichten in diesen bevorzugten Ausführungsformen sind Schichten aus gut polierbarem Material. Vorteilhafterweise weist die Polierschicht ein oder mehrere Materialien der Gruppe amorphes Silizium, Siliziumdioxid, Siliziumnitrid, Galliumnitrid und Aluminiumnitrid auf. Amorphes Silizium ist mit üblichen physikalischen und chemischen Abscheidungsverfahren aus der Gasphase (PVD- bzw. CVD-Verfahren) aufbringbar und lässt sich mit Standard-Polierverfahren auf die genannten Rauheitsgrade polieren. Ebenfalls geeignet, um im Ortsfrequenzbereich von 0,1 µm bis 200 µm eine RMS-Rauheit von nicht mehr als 0,2 nm zu erreichen und mittels üblicher PVD- bzw. CVD-Verfahren aufgebracht zu werden, sind Siliziumdioxid, Siliziumnitrid, Galliumnitrid und Aluminiumnitrid als Polierschichtmaterial.

Bevorzugt ist in diesen bevorzugten Ausführungsformen die funktionale Schicht zwischen der Polierschicht und der reflektiven Beschichtung angeordnet. Dies ist insbesondere bei Polierschichten von Vorteil, die amorphes Silizium oder auch Siliziumdioxid oder Siliziumnitrid aufweisen. Denn Silizium weist vergleichsweise hohe Rekombinationsraten von reaktivem zu molekularem Wasserstoff und somit ein erhöhtes Risiko der Ansammlung von Wasserstoffgas an der Grenzfläche von Polierschicht zu reflektiver Beschichtung auf. So kann die funktionale Schicht an dieser Grenzfläche besonders gut ihre Wirkung entfalten und durch Reduktion der Wasserstoffkonzentration ein Delaminieren der reflektiven Beschichtung unterdrücken.

In bevorzugten Ausführungsformen weist das Substrat eines oder mehrere der Materialien der Gruppe Silizium, Siliziumkarbid (SiSiC), siliziuminfiltriertes Siliziumkarbid, Quarzglas, titandotiertes Quarzglas, Glas, Glaskeramik auf. Bei diesen Substratmaterialien ist eine höhere Rekombinationsrate von reaktivem zu molekularem Wasserstoff zu beobachten, so dass die funktionale Schicht besonders gut ihre Wirkung entfalten und ein Delaminieren an der Grenzfläche zum Substrat unterdrücken kann. Ferner kann das Substrat auch aus Kupfer, Aluminium, einer Kupferlegierung, einer Aluminiumlegierung oder einer Kupfer-Aluminium-Legierung sein.

In bevorzugten Ausführungsformen ist die reflektive Beschichtung als Viellagensystem ausgebildet, das alternierend angeordnete Lagen eines Materials mit einem geringeren Realteil des Brechungsindex bei einer Arbeitswellenlänge im Wellenlängenbereich zwischen 5 nm und 20 nm und eines Materials mit einem höheren Realteil des Brechungsindex bei einer Arbeitswellenlänge im Wellenlängenbereich zwischen 5 nm und 20 nm aufweist. Derartige reflektive optische Elemente sind besonders für den Einsatz bei normalem oder quasi-normalem Einfall geeignet.

Besonders bevorzugt ist das reflektive optische Element für die EUV-Lithographie als Kollektorspiegel ausgebildet. Insbesondere wenn sie als Kollektorspiegel zusammen mit Plasmastrahlungsquellen beispielsweise auf der Basis von Zinn betrieben werden, werden sie zu Reinigungszwecken besonders oft und hohen Konzentrationen von reaktivem Wasserstoff ausgesetzt. Bei Kollektorspiegeln kann sich die Antidelaminationswirkung der funktionalen Schicht besonders deutlich auswirken.

Ferner wird die Aufgabe gelöst durch ein optisches System für eine EUV-Lithographievorrichtung mit einem reflektiven optischen Element wie zuvor beschrieben bzw. auf eine EUV-Lithographievorrichtung mit einem solchen optischen System oder einem solchen reflektiven optischen Element.

Die vorliegende Erfindung soll unter Bezugnahme auf bevorzugte Ausführungsbeispiele näher erläutert werden. Dazu zeigen
- Figur 1: schematisch eine Ausführungsform einer EUV-Lithographievorrichtung mit reflektiven optischen Elementen;
- Figur 2: schematisch eine erste Ausführungsform eines reflektiven optischen Elements;
- Figur 3: schematisch eine zweite Ausführungsform eines reflektiven optischen Elements;
- Figur 4: schematisch eine dritte Ausführungsform eines reflektiven optischen Elements;
- Figur 5: schematisch eine vierte Ausführungsform eines reflektiven optischen Elements;
- Figur 6: schematisch eine fünfte Ausführungsform eines reflektiven optischen Elements;
- Figur 7: schematisch eine sechste Ausführungsform eines reflektiven optischen Elements; und
- Figur 8: schematische eine siebte Ausführungsform eines reflektiven optischen Elements.

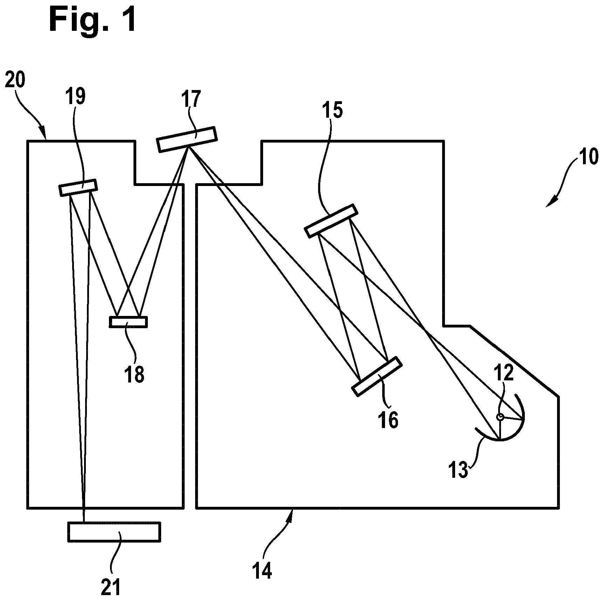

In Figur 1 ist schematisch eine EUV-Lithographievorrichtung 10 dargestellt. Wesentliche Komponenten sind das Beleuchtungssystem 14, die Photomaske 17 und das Projektionssystem 20. Die EUV-Lithographievorrichtung 10 wird unter Vakuumbedingungen betrieben, damit die EUV-Strahlung in ihrem Inneren möglichst wenig absorbiert wird.

Als Strahlungsquelle 12 kann beispielsweise eine Plasmaquelle oder auch ein Synchrotron dienen. Im hier dargestellten Beispiel handelt es sich um eine Plasmaquelle. Die emittierte Strahlung im Wellenlängenbereich von etwa 5 nm bis 20 nm wird zunächst vom Kollektorspiegel 13 gebündelt. Der Betriebsstrahl wird dann in das Beleuchtungssystem 14 eingeführt. Im in Figur 1 dargestellten Beispiel weist das Beleuchtungssystem 14 zwei Spiegel 15, 16 auf. Die Spiegel 15, 16 leiten den Strahl auf die Photomaske 17, die die Struktur aufweist, die auf den Wafer 21 abgebildet werden soll. Bei der Photomaske 17 handelt es sich ebenfalls um ein reflektives optisches Element für den EUV- und weichen Röntgenwellenlängenbereich, das je nach Herstellungsprozess ausgewechselt wird. Mit Hilfe des Projektionssystems 20 wird der von der Photomaske 17 reflektierte Strahl auf den Wafer 21 projiziert und dadurch die Struktur der Photomaske auf ihn abgebildet. Das Projektionssystem 20 weist im dargestellten Beispiel zwei Spiegel 18, 19 auf. Es sei darauf hingewiesen, dass sowohl das Projektionssystem 20 als auch das Beleuchtungssystem 14 jeweils nur einen oder auch drei, vier, fünf und mehr Spiegel aufweisen können.

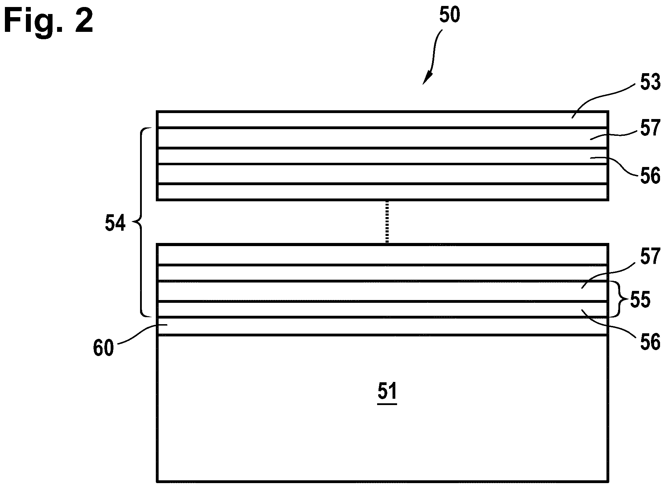

Im hier dargestellten Beispiel handelt es sich bei dem Kollektorspiegel 13 um einen Spiegel 50 für quasi-normalen Einfall, dessen reflektive Beschichtung auf einem Viellagensystem 54 basiert, wie schematisch in den Figuren 2 bis 8 dargestellt. Dabei handelt es sich um alternierend aufgebrachte Lagen eines Materials mit höherem Realteil des Brechungsindex bei der Arbeitswellenlänge, bei der beispielsweise die lithographische Belichtung durchgeführt wird, (auch Spacer 56 genannt) und eines Materials mit niedrigerem Realteil des Brechungsindex bei der Arbeitswellenlänge (auch Absorber 57 genannt), wobei ein Absorber-Spacer-Paar einen Stapel 55 bildet. Dadurch wird in gewisser Weise ein Kristall simuliert, dessen Netzebenen den Absorberlagen entsprechen, an denen Bragg-Reflexion stattfindet. Die Dicken der einzelnen Lagen 56, 57 wie auch der sich wiederholenden Stapel 55 können über das gesamte Viellagensystem 54 konstant sein oder auch variieren, je nach dem, welches spektrale oder winkelabhängige Reflexionsprofil erreicht werden soll. Das Reflexionsprofil kann auch gezielt beeinflusst werden, indem die Grundstruktur aus Absorber 57 und Spacer 56 um weitere mehr und weniger absorbierende Materialien ergänzt wird, um die mögliche maximale Reflektivität bei der jeweiligen Arbeitswellenlänge zu erhöhen. Dazu können in manchen Stapeln Absorber- und/oder Spacer-Materialien gegeneinander ausgetauscht werden oder die Stapel aus mehr als einem Absorber- und/oder Spacermaterial aufgebaut werden. Die Absorber- und Spacermaterialien können über alle Stapel konstante oder auch variierende Dicken aufweisen, um die Reflektivität zu optimieren. Ferner können auch zusätzliche Lagen als Diffusionsbarrieren zwischen Spacer- und Absorberlagen 56, 57 vorgesehen werden. Eine beispielsweise für eine Arbeitswellenlänge von 13,4 nm übliche Materialkombination ist Molybdän als Absorber- und Silizium als Spacermaterial. Dabei hat ein Stapel 55 meist eine Dicke von 6,7 nm, wobei die Spacerlage 56 meist dicker ist als die Absorberlage 57.

Im hier dargestellten Beispiel weist die reflektive Beschichtung 54 auch eine Schutzschicht 53 auf, die auch aus mehr als einer Lage bestehen kann. Die Schutzschicht 53 kann beispielsweise bei einem Molybdän-Silizium-Viellagensystem u.a. aus einer Lage Siliziumnitrid und einer Lage Ruthenium als Abschluss zum Vakuum aufgebaut sein. Es kann sich beispielsweise auch um ein Schutzschichtsystem handeln, wie es in der WO 2014/139694 A1 beschrieben wird. Die reflektive Beschichtung 54 ist auf einem Substrat 51 angeordnet. Typische Substratmaterialien für reflektive optische Elemente für die EUV-Lithographie, insbesondere Kollektorspiegel, sind Silizium, Siliziumkarbid, siliziuminfiltriertes Siliziumkarbid, Quarzglas, titandotiertes Quarzglas, Glas und Glaskeramik. Ferner kann das Substrat auch aus Kupfer, Aluminium, einer Kupferlegierung, einer Aluminiumlegierung oder einer Kupfer-Aluminium-Legierung sein.

In einer hier nicht dargestellten Variante kann der Kollektorspiegel auch als Spiegel für streifenden Einfall ausgebildet sein. Dazu kann er beispielsweise auf einem Substrat aus einer Kupfer- oder Aluminiumlegierung eine Polierschicht aus u.a. Nickel-Phosphor oder amorphem Silizium sowie darüber eine Rutheniumschicht als reflektive Beschichtung aufweisen. Optional kann er zusätzlich eine mikrostrukturierte Schicht aufweisen, um beispielsweise ultraviolette oder Infrarotstrahlung aus dem Strahlengang herauszufiltern.

In dem hier dargestellten Beispiel kann die Strahlungsquelle eine Plasmastrahlungsquelle sein, bei der Zinntröpfchen mittels CO₂-Laser zu einem Plasma angeregt werden, das Strahlung im EUV-Wellenlängenbereich emittiert. Dabei kann Zinn in die EUV-Lithographievorrichtung eindringen und sich auf insbesondere der Oberfläche des Kollektorspiegels niederschlagen. Bei den im Strahlengang folgenden reflektiven optischen Elementen ist die Zinnkontamination vernachlässigbar und kann vor allem Kontamination auf der Basis von Sauerstoff oder Kohlenstoff auftreten. Um insbesondere die Zinn- und Kohlenstoff-Kontamination auf den Beschichtungen der reflektiven optischen Elemente einer EUV-Lithographievorrichtung zu reduzieren, werden sie im Vakuum mit einer Beimischung von Wasserstoff bei geringem Partialdruck betrieben. Unter Einfluss der EUV-Strahlung bildet sich aus dem molekularen Wasserstoff reaktiver Wasserstoff in der Form von Wasserstoffradikalen und Wasserstoffionen. Letztere wandeln sich durch Wandstöße zu einem großen Teil in Wasserstoffradikale um. Der reaktive Wasserstoff bildet flüchtige Zinn- bzw. Kohlenstoffverbindungen, die abgepumpt werden können.

Insbesondere wenn in der reflektiven Beschichtung im Betrieb oder bereits in der Fertigung entstandene Störstellen vorliegen, wie etwa Poren, Einschlüsse, Versetzungen oder mechanische Beschädigungen, wie etwa Kratzer oder Risse, kann ein Eindringen von reaktiven Wasserstoff in die reflektive Beschichtung beobachtet werden, der unter anderem unter der reflektiven Beschichtung rekombiniert. Die Umwandlung in molekularen Wasserstoff führt zu einer Volumenvergrößerung. Es bilden sich Blasen unter der reflektiven Beschichtung, was zu einem lokalen Abblättern eines Teils oder der gesamten reflektiven Beschichtung führen kann. Vor allem an Grenzflächen zu Siliziumlagen oder -Schichten bzw. siliziumhaltigen Lagen oder Schichten scheint es häufiger zu einer Delaminierung zu kommen. Delaminierte Stellen haben eine hohe Reflektivität im Infrarot-Bereich. Dies ist insbesondere bei Kollektorspiegeln problematisch, wenn sie in Verbindung mit einer Laserplasmastrahlungsquelle eingesetzt werden, aus der wegen des Lasers nicht nur EUV-Strahlung, sondern auch vermehrt Infrarot-Strahlung austritt. Sollte zuviel Infrarotstrahlung in den weiteren Strahlengang eingekoppelt werden, könnten die nachfolgenden Spiegel und die Photomaske beschädigt werden.

Bislang müssen durch Wasserstoffeinfluss dahingehend beschädigte reflektive optische Elemente, dass die reflektive Beschichtung auf- oder abgeplatzt ist, quasi neu hergestellt werden, indem die gesamte Beschichtung komplett entfernt und das Substrat neu beschichtet werden muss. Bei den im folgenden vorgestellten beispielhaften Ausführungsformen, ist das Risiko reduziert, dass es zu einer Delamination der reflektierenden Beschichtung kommt. Ohne Beschränkung der Allgemeinheit handelt es sich in den in den Figuren 2 bis 8 dargestellten Beispielen bei den reflektiven optischen Elementen 50 für die EUV-Lithographie um Kollektorspiegel für quasi-normalen Einfall.

In dem in Figur 2 dargestellten Beispiel ist zwischen dem Substrat 51 und der reflektiven Beschichtung 54 eine funktionale Schicht 60 vorgesehen. Sie kann ein- oder mehrlagig ausgebildet sein und weist ein oder mehrere Materialien der Gruppe Zinn, Silber, Molybdän, Ruthenium, Iridium, Nickel, Eisen, Kobalt, Kupfer, Aluminium, Platin, Zink, Mangan, Blei, Gold, Palladium, Wolfram, Tantal, deren Legierungen, deren Oxide, Boride, Nitride und Karbide auf, bei denen man beobachtet hat, dass sie als Diffusionsbarriere gegen reaktiven Wasserstoff wirken können und die Konzentration von Wasserstoff in Atom-% an der der reflektiven Beschichtung zugewandten Seite des Substrats um mindestens einen Faktor 2, bevorzugt von mindestens 5, besonders bevorzugt von mindestens 10, ganz besonders bevorzugt von mindestens 50 und überaus besonders bevorzugt von mindestens 100 reduzieren können, verglichen mit einem identischen reflektiven optischen Element ohne diese funktionale Schicht. In bevorzugten Fällen besteht sie aus einer Lage aus einem der genannten Materialien. Vorteilhafterweise wird bei der Materialwahl berücksichtigt, dass eine gute Haftung zum Substrat und zur über der funktionalen Schicht liegenden Lage oder Schicht besteht und/oder ähnliche Wärmeausdehnungskoeffizienten vorliegen.

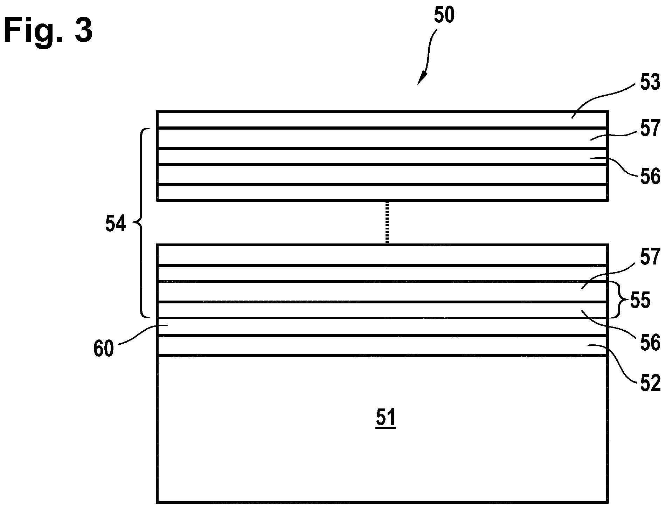

Das in Figur 3 dargestellte Beispiel weist zwischen der funktionalen Schicht 60 und dem Substrat 51 zusätzlich eine Polierschicht 52 auf. Diese ist bevorzugt aus amorphem Silizium, Siliziumdioxid, Siliziumnitrid, Galliumnitrid oder Aluminiumnitrid und kann nicht nur auf Substraten aus Glas, Glaskeramik, Quarzglas, dotiertes Quarzglas, Silizium, Siliziumkarbid und siliziuminfiltriertes Siliziumkarbid, sondern auch auf Substraten aus Kupfer, Aluminium oder deren Legierungen angeordnet werden. Besonders bevorzugt wird auf der Polierschicht 52 eine funktionale Schicht 60 aus einer Lage aus Zinn, Zinnoxid, Zinnnitrid, Ruthenium, Iridium, Nickel, Eisen, Kobalt, Kupfer, Silber, Aluminium oder auch deren Oxiden, Boriden, Nitriden und Karbiden aufgebracht, insbesondere bei Polierschichten aus amorphem Silizium.

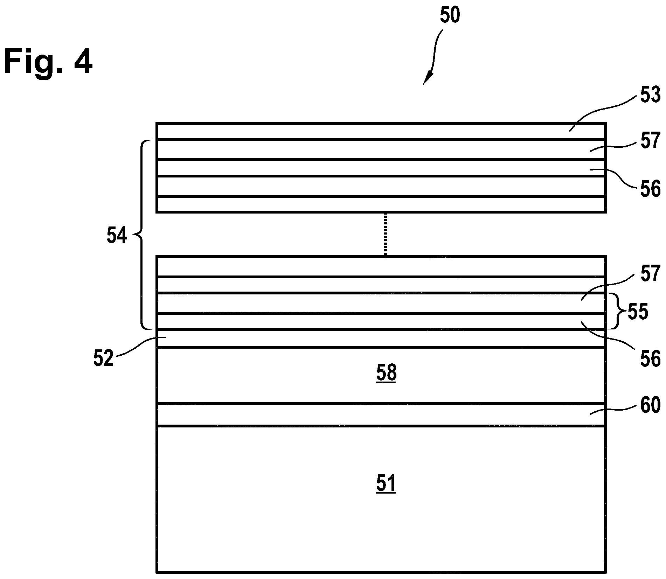

Bei dem in Figur 4 dargestellten Beispiel ist zwischen Substrat 51 und reflektiver Beschichtung 54 eine mikrostrukturierte Schicht 58 vorgesehen. Sie dient dazu, Strahlung aus ungewollten Wellenlängenbereichen wie etwa von der Strahlungsquelle 12 ebenfalls emittierte ultraviolette Strahlung oder die Infrarotstrahlung, mit der das Plasma der Strahlungsquelle 12 angeregt wird, aus dem Strahlengang der Arbeitsstrahlung im EUV-Wellenlängenbereich durch destruktive Interferenz zu filtern. Dazu kann die mikrostrukturierte Schicht 58 beispielsweise eine Beugungsgitterstruktur aufweisen. Die mikrostrukturierte Schicht 58 ist im vorliegenden Beispiel aus einem oder mehrere Materialien der Gruppe Nickel-Phosphor, Nickel-Bor, Kupfer, Silber, Gold, Platin, Iridium, Tantal, Titan, Zirkonium, Wolfram, Molybdän und Niob, bevorzugt aus Nickel-Phosphor, Nickel-Bor, Kupfer oder Silber und weist eine Dicke von wenigen bis einigen hundert Mikrometern auf. Auf der mikrostrukturierten Schicht 58 ist beschichtungsseitig eine Polierschicht 52 angeordnet, die aber in Varianten auch weggelassen werden kann, und substratseitig eine funktionale Schicht 60. Dadurch kann das Delaminierungsrisiko aufgrund Wasserstoffdiffusion verringert werden.

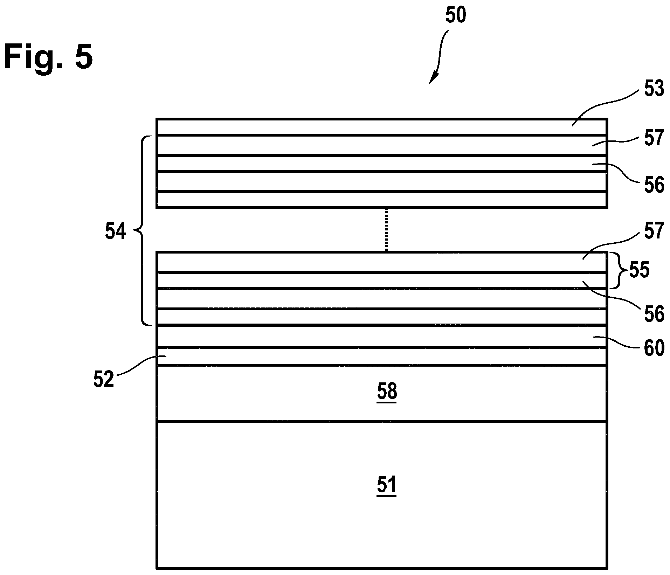

In der in Figur 5 dargestellten Ausführungsvariante ist hingegen die funktionale Schicht 60 zwischen der Polierschicht 52, die auf der mikrostrukturierten Schicht 58 angeordnet ist, und der reflektiven Beschichtung 54 vorgesehen. Die mikrostrukturierte Schicht 58 ist in dieser beispielhaften Ausführungsform bevorzugt Tantal, Titan, Zirkonium, Wolfram, Molybdän und Niob, die eine besonders gute Haftung zwischen Metalle, wie sie für die mikrostrukturierte Schicht 58 verwendet werden, und Substraten 51 aus Silizium, Siliziumkarbid, siliziuminfiltriertes Siliziumkarbid, Quarzglas, titandotiertes Quarzglas, Glas, Glaskeramik vermitteln. Dadurch kann das Delaminierungsrisiko zusätzlich verringert werden. In nicht dargstellten Abwandlungen kann die Haftwirkung auch zur reflektiven Beschichtung oder ggf. Polierschicht so hoch sein, dass auf eine wasserstoffkonzentrationsmindernde funktionale Schicht verzichtet werden kann. In weiteren nicht dargestellten Abwandlungen kann auch auf die Polierschicht verzichtet werden. Bevorzugt werden als Materialien für die funktionale Schicht 60 auf einer mikrostrukturierten Schicht 58 Materialien mit guter Beständigkeit gegenüber äußeren mechanischen Einflüssen ausgewählt. Vorteilhafterweise weisen sie eine geringe intrinsische Aufrauhung durch Beschichtungsprozesse auf und/oder sollten eine gute Überdeckung möglicher Defekte in der mikrostrukturierten Schicht 58 ermöglichen. Es ist auch von Vorteil, wenn sie eine gute Haftung zur mikrostrukturierten Schicht 58 und der reflektiven Beschichtung 54 aufweist. Besonders geeignet als Materialien für die funktionale Schicht 60 auf einer mikrostrukturierten Schicht 58 sind beispielsweise Palladium, Wolfram und Oxide wie etwa Tantaloxid und Aluminiumoxid.

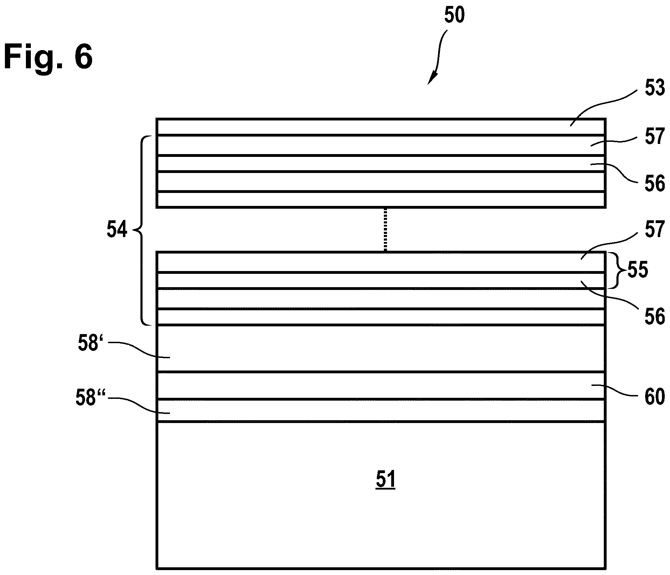

In der in Figur 6 dargestellten Ausführungsvariante ist die funktionale Schicht 60 innerhalb der mikrostrukturierten Schicht angeordnet, die durch die funktionale Schicht 60 im vorliegenden Beispiel in eine mikrostrukturierte Teilschicht 58' und eine weitere Teilschicht 58" aufgeteilt ist. In dieser Ausführungsvariante wird das Diffundieren von Wasserstoff bis an die Grenzfläche von Substrat 51 zu Teilschicht 58" sowie in die Teilschicht 58" möglichst unterbunden, insbesondere falls, die reflektive Beschichtung stellenweise beschädigt sein oder Defekte aufweisen sollte.

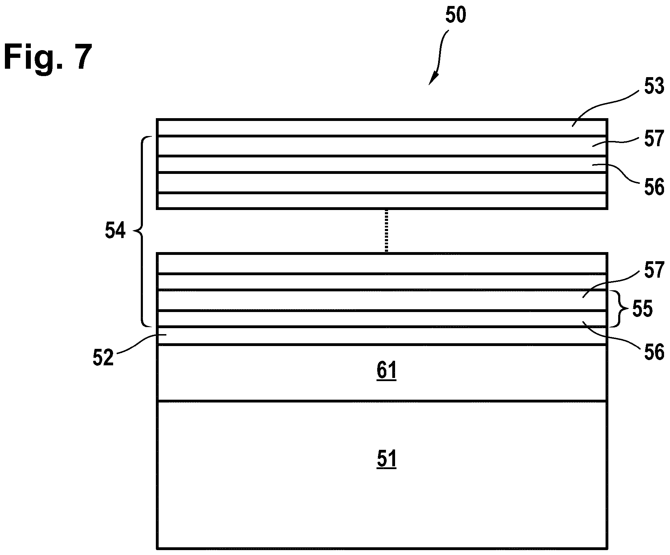

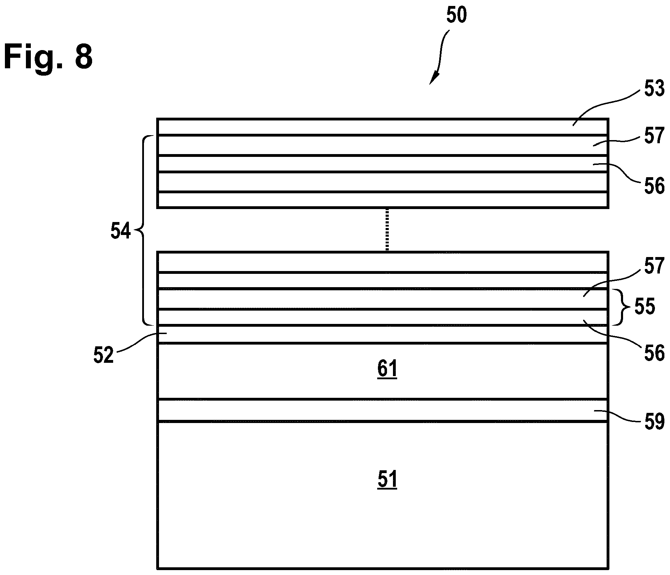

Die beiden in den Figuren 7 und 8 dargestellten Ausführungsvarianten weisen die Besonderheit auf, dass die funktionale Schicht 61 als mikrostrukturierte Schicht ausgebildet ist und ein oder mehrere der Materialien der Gruppe Zinn, Silber, Molybdän, Ruthenium, Iridium, Nickel, Eisen, Kobalt, Kupfer, Aluminium, Platin, Zink, Mangan, Blei, deren Oxide, Boride, Nitride und Karbide, bevorzugt Zinnoxid und/oder Zinnnitrid aufweist. Zu diesem Zweck weist sie eine Dicke auf, die nicht nur im Bereich von einigen Nanometern bis Mikrometern liegt, wie bei den zuvor diskutierten funktionalen Schichten 60, sondern von mindestens einigen hundert Mikrometern. Um sie aufzubringen, werden bevorzugt Beschichtungsverfahren mit besonders hohen Abscheidungsraten eingesetzt, wie z.B. Atmosphären-Druck-Plasmaabscheidung, Gasfluss-Plasmaabscheidung, Vakuumbogen-Plasmabeschichtung, galvanische Abscheidung aus nicht-wässrigen Elektrolyten oder plasmaunterstützte chemische Abscheidung aus der Gasphase (PE-CVD). Für die Herstellung der zuvor diskutierten funktionalen Schichten 60 können auch alle anderen üblichen Verfahren zur physikalischen oder chemischen Abscheidung aus der Gasphase eingesetzt werden, insbesondere Sputterverfahren oder Verfahren zum Elektronenstrahlverdampfen.

In der in Figur 7 beispielhaft dargestellten Ausführungsform ist die als mikrostrukturierte Schicht ausgeführte funktionale Schicht 61 ein- oder mehrlagig ausgeführt und unmittelbar auf dem Substrat 51 angeordnet.

In der in Figur 8 beispielhaft dargestellten Ausführungsform ist die als mikrostrukturierte Schicht ausgeführte funktionale Schicht 61 bevorzugt aus Ruthenium, Iridium, Nickel, Eisen, Kobalt, Kupfer, Silber, Aluminium oder auch deren Oxiden, Boriden, Nitriden und Karbiden und besonders bevorzugt aus Zinn, Zinnoxid oder Zinnnitrid, die eine besonders gute Barrierewirkung gegen reaktiven Wasserstoff aufzuweisen scheinen. Zusätzlich ist zwischen dieser Schicht 61 und dem Substrat 51 aus Silizium, Siliziumkarbid, siliziuminfiltriertes Siliziumkarbid, Quarzglas, titandotiertes Quarzglas, Glas oder Glaskeramik eine Haftvermittlerschicht 59 vorgesehen, die ein- oder zweilagig ausgeführt ist, bevorzugt aus Ruthenium, Iridium, Platin, Kupfer, Silber, Gold, Nickel, Nickel-Phosphor, Chrom, Tantal, Titan, Zirkonium, Niob, Wolfram oder Molybdän, die das Delaminationsrisiko zusätzlich durch eine verbesserte Haftung mindern können. Besonders bevorzugt ist die funktionale Schicht 62 zweilagig aus einer substratabgewandten Lage aus Ruthenium, Iridium, Platin oder Kupfer und eine substratseitige Lage aus Chrom, Tantal, Titan, Zirkonium, Niob, Wolfram oder Molybdän. Um die Haftung mit oder ohne Haftvermittlerschicht 59 zu verbessern, kann es nützlich sein eine Schichtoberfläche, insbesondere die des Substrats 51 chemisch zu reinigen, bevor die nächste Schicht, insbesondere eine Haftvermittlerschicht oder die funktionale Schicht aufgebracht wird. Je nach tatsächlicher Materialwahl kann u.a. mit einer alkalischen Substanz wie etwa Kaliumhydroxid oder Natriumhydroxid oder mit einer sauren Substanz wie etwa Schwefelsäure oder Salpetersäure gereinigt werden.

Es sei darauf hingewiesen, dass die hier vorgestellten Ausführungsformen auch miteinander kombiniert werden können.

Die bisherigen Erfahrungen lassen erwarten, dass die zuvor beschriebenen Spiegel mit funktionaler Schicht zwischen reflektiver Beschichtung und Substrat eine erhöhte Widerstandskraft gegen Delaminieren der reflektiven Beschichtung aufweisen sowie eine um mindestens einen Faktor 2 reduzierte Wasserstoffkonzentration in Atom-% an der der reflektiven Beschichtung zugewandten Seite des Substrats.

Zur Bestimmung der Wasserstoffkonzentration in Atom-% an der der reflektiven Beschichtung zugewandten Seite des Substrats sind insbesondere die Messmethoden der Kernreaktionsanalyse oder der elastischen Rückstreuanalyse geeignet. Dabei wird die Wasserstoffkonzentration eines hier vorgeschlagenen Spiegels mit der eines identischen Spiegels ohne die funktionale Schicht verglichen.

Eine besonders hohe Widerstandskraft gegen wasserstoffbedingtes Delaminieren der reflektiven Beschichtung wird u.a. für Kollektorspiegel für die EUV-Lithographie entsprechend dem in Verbindung mit Figur 7 beschriebenen erwartet. Bevorzugt weisen sie als reflektive Beschichtung ein Viellagensystem auf der Basis von alternierenden Molybdän- und Siliziumlagen wie zuvor beschrieben auf. Als Schutzschicht können sie eine Zirkoniumnitridschicht von wenigen Nanometern aufweisen. Auf einem Substrat aus siliziuminfiltriertem Siliziumkarbid ist bevorzugt eine als mikrostrukturierte Schicht ausgebildete funktionale Schicht aus wahlweise jeweils Zinn, Zinnoxid oder Zinnnitrid angeordnet. Auf dieser funktionalen Schicht kann zur reflektiven Beschichtung hin eine einige Nanometer dicke Polierschicht aus amorphem Silizium einer RMS-Rauheit von weniger als 0,2 nm im Ortsfrequenzbereich von 0,1 µm bis 200 µm angeordnet sein. Bevorzugt ist zwischen Substrat und der funktionalen Schicht eine zweilagig ausgeführte Haftvermittlerschicht angeordnet aus substratseitig einer Chrom-Lage und darüber einer Ruthenium-Lage, beide einer Dicke von mehreren Nanometern. Es wird erwartet, dass derartige Kollektorspiegel weder nach mehreren ex-situ-Zinnreinigung mit Reinigungsraten in der Größenordnung von Mikrometern pro Stunde mit reaktivem Wasserstoff noch nach 1500 h Betrieb mit einer Zinnplasma-Quelle bei einer Leistung von mehr als 50 W bei niedrigem Wasserstoffpartialdruck zur Vermeidung von zu starkem Aufwachsen von Zinnkontamination wasserstoffgeneriertes Delaminieren der reflektiven Beschichtung vom Substrat zeigen. Es wird davon ausgegangen, dass die als mikrostrukturierte Schicht ausgebildete funktionale Schicht aus Zinn bzw. insbesondere aus Zinnoxid oder Zinnnitrid zu einer Reduktion der Wasserstoffkonzentration in Atom-% an der der reflektiven Beschichtung zugewandten Seite des Substrats um einen Faktor von bis über 100 führen kann.

Ähnliches wird vermutet für Spiegel für streifenden Einfall, die beispielsweise als reflektive Beschichtung eine wenige hundert Nanometer dicke Rutheniumschicht auf einer ebenfalls wenige bis einige hundert Nanometer dicken Polierschicht aus amorphem Silizium aufweisen Darunter ist auf beispielsweise einem Aluminiumsubstrat zusätzlich eine als mikrostrukturierte Schicht mit Spektralfilterfunktion ausgebildete funktionale Schicht aus bevorzugt Zinn, Zinnnitrid oder besonders bevorzugt Zinnoxid einer Dicke von wenigen bis einigen hundert Mikrometern angeordnet. Es wird davon ausgegangen, dass auch diese als mikrostrukturierte Schicht ausgebildete funktionale Schicht aus Zinn, Zinnnitrid oder Zinnoxid zu einer Reduktion der Wasserstoffkonzentration in Atom-% an der der reflektiven Beschichtung zugewandten Seite des Substrats um einen Faktor von bis über 100 führen kann.

Auch für Spiegel, die etwa entsprechend dem in Verbindung mit Figur 2 diskutierten Aufbau eine funktionale Schicht einer Dicke von nur wenigen zehn Nanometern aufweisen, wird eine messbare Reduktion der Wasserstoffkonzentration in Atom-% an der der reflektiven Beschichtung zugewandten Seite des Substrats erwartet, und zwar um einen Faktor von mindestens 5. Er kann auch über 10 oder sogar über 50 liegen. Besonders bevorzugt sind funktionale Schichten aus Zinn und insbesondere Zinnoxid oder Zinnnitrid. Aber auch bei Spiegeln mit einer funktionalen Schicht, die andere der Materialien der Gruppe Zinn, Silber, Molybdän, Ruthenium, Iridium, Nickel, Eisen, Kobalt, Kupfer, Aluminium, Platin, Zink, Mangan, Blei, deren Oxide, Boride, Nitride und Karbide aufweist, können vergleichbare Ergebnisse erwartet werden. Dies gilt auch für als mikrostrukturierte Schicht ausgeführte funktionale Schichten.

In weiteren Varianten, insbesondere mit einem Aufbau, der in etwa dem in Verbindung mit den Figuren 4 bis 6 diskutierten Aufbau entspricht, kann eine signifikante Reduktion der Wasserstoffkonzentration in Atom-% an der der reflektiven Beschichtung zugewandten Seite des Substrats um einen Faktor 2 oder größer erreicht werden mit einer funktionalen Beschichtung aus bevorzugt Silber, Gold, Kupfer, Platin, Aluminium, Aluminiumoxid, Eisen, Eisen-Nickel-Kobalt-Legierungen, Palladium, Wolfram und/oder Tantaloxid erreicht werden. Die funktionale Schicht kann dabei eine Dicke von 1 µm oder mehr aufweisen, um insbesondere das Ausgleichen von Unebenheiten im Substrat oder der mikrostrukturierten Schicht sowie eine geschlossene Schicht sicherstellen zu können. Dazu kann die funktionale Schicht bevorzugt galvanisch, plasmaunterstützt oder durch thermisches oder ionenbasiertes Verdampfen aufgebracht werden.

### Bezugszeichen

- 10: EUV-Lithographievorrichtung
- 12: EUV-Strahlungsquelle
- 13: Kollektorspiegel
- 14: Beleuchtungssystem
- 15: erster Spiegel
- 16: zweiter Spiegel
- 17: Maske
- 18: dritter Spiegel
- 19: vierter Spiegel
- 20: Projektionssystem
- 21: Wafer
- 50: Kollektorspiegel
- 51: Substrat
- 52: Polierschicht
- 53: Schutzlage
- 54: Viellagensystem
- 55: Lagenpaar
- 56: Absorber
- 57: Spacer
- 58: mikrostrukturierte Schicht
- 58': mikrostrukturierte Teilschicht
- 58": Teilschicht
- 59: Haftvermittlerschicht
- 60: funktionale Schicht
- 61: als mikrostrukturierte Schicht ausgebildete funktionale Schicht

## Patentansprüche

1. Reflektives optisches Element für die EUV-Lithographie, aufweisend ein Substrat und eine reflektive Beschichtung zur Reflexion von Strahlung im Wellenlängenbereich von 5 nm bis 20 nm, **dadurch gekennzeichnet, dass** zwischen der reflektiven Beschichtung (54) und dem Substrat (51) eine funktionale Schicht (60, 61), durch die die Konzentration von Wasserstoff in Atom-% an der der reflektiven Beschichtung zugewandten Seite des Substrats um mindestens einen Faktor 2 reduziert wird, und eine mikrostrukturierte Schicht (58) angeordnet sind und auf der funktionalen Schicht (60) oder der mikrostrukturierte Schicht (58) eine Polierschicht (52) angeordnet ist und auf dem Substrat eine Haftvermittlerschicht (59) angeordnet ist, die aus mindestens einer Lage besteht und ein oder mehrere Materialien der Gruppe aus Ruthenium, Chrom, Platin, Iridium, Kupfer, Silber, Gold, Nickel, Nickel-Phosphor, Tantal, Titan, Zirkonium, Wolfram, Molybdän und Niob aufweist.

2. Reflektives optisches Element nach Anspruch 1, **dadurch gekennzeichnet, dass** die funktionale Schicht (60, 61) eines oder mehrere der Materialien der Gruppe Zinn, Silber, Molybdän, Ruthenium, Iridium, Nickel, Eisen, Kobalt, Kupfer, Aluminium, Platin, Zink, Mangan, Blei, Gold, Palladium, Wolfram, Tantal, deren Legierungen, Oxide, Boride, Nitride und Karbide aufweist.

3. Reflektives optisches Element nach Anspruch 1 oder 2, **dadurch gekennzeichnet, dass** die mikrostrukturierte Schicht (58) ein oder mehrere Materialien der Gruppe Nickel-Phosphor, Nickel-Bor, Kupfer, Silber, Gold, Platin, Iridium, Tantal, Titan, Zirkonium, Wolfram, Molybdän und Niob aufweist.

4. Reflektives optisches Element nach einem der Ansprüche 1 bis 3, **dadurch gekennzeichnet, dass** die funktionale Schicht (60) zwischen der reflektiven Beschichtung (54) und der mikrostrukturierte Schicht (58) und/oder zwischen der mikrostrukturierte Schicht (58) und dem Substrat (51) und/oder innerhalb der mikrostrukturierten Schicht (58) angeordnet ist.

5. Reflektives optisches Element nach einem der Ansprüche 1 bis 4, **dadurch gekennzeichnet, dass** die Polierschicht (52) ein oder mehrere Materialien der Gruppe amorphes Silizium, Siliziumdioxid, Siliziumnitrid, Galliumnitrid und Aluminiumnitrid aufweist.

6. Reflektives optisches Element nach einem der Ansprüche 1 bis 5, **dadurch gekennzeichnet, dass** die funktionale Schicht (60) zwischen der Polierschicht (52) und der reflektiven Beschichtung (54) angeordnet ist.

7. Reflektives optisches Element nach einem der Ansprüche 1 bis 6, **dadurch gekennzeichnet, dass** das Substrat (51) eines oder mehrere der Materialien der Gruppe Silizium, Siliziumkarbid, siliziuminfiltriertes Siliziumkarbid, Quarzglas, titandotiertes Quarzglas, Glas, Glaskeramik aufweist.

8. Reflektives optisches Element nach einem der Ansprüche 1 bis 7, **dadurch gekennzeichnet, dass** die reflektive Beschichtung als Viellagensystem (54) ausgebildet ist, das alternierend angeordnete Lagen (56, 57) eines Materials mit einem geringeren Realteil des Brechungsindex bei einer Arbeitswellenlänge im Wellenlängenbereich zwischen 5 nm und 20 nm und eines Materials mit einem höheren Realteil des Brechungsindex bei einer Arbeitswellenlänge im Wellenlängenbereich zwischen 5 nm und 20 nm aufweist.

9. Reflektives optisches Element nach einem der Ansprüche 1 bis 8, **dadurch gekennzeichnet, dass** es als Kollektorspiegel (13, 50) ausgebildet ist.

10. Optisches System für eine EUV-Lithographievorrichtung mit einem reflektiven optischen Element gemäß einem der Ansprüche 1 bis 9.

11. EUV-Lithographievorrichtung mit einem optischen System gemäß Anspruch 10 oder einem reflektiven optischen Element gemäß einem der Ansprüche 1 bis 9.

## Claims

1. Reflective optical element for EUV lithography, comprising a substrate and a reflective coating for reflecting radiation in the wavelength range of 5 nm to 20 nm, **characterized in that** a functional layer (60, 61), by means of which functional layer the concentration of hydrogen in atom% at the side of the substrate facing the reflective coating is reduced by at least a factor of 2, and a microstructured layer (58) are arranged between the reflective coating (54) and the substrate (51) and a polishing layer (52) is arranged on the functional layer (60) or the microstructured layer (58) and an adhesion promoter layer (59) is arranged on the substrate, said adhesion promoter layer consisting of at least one ply and comprising one or more materials of the group consisting of ruthenium, chromium, platinum, iridium, copper, silver, gold, nickel, nickel-phosphorus, tantalum, titanium, zirconium, tungsten, molybdenum and niobium.

2. Reflective optical element according to Claim 1, **characterized in that** the functional layer (60, 61) comprises one or more of the materials of the group tin, silver, molybdenum, ruthenium, iridium, nickel, iron, cobalt, copper, aluminium, platinum, zinc, manganese, lead, gold, palladium, tungsten, tantalum, alloys, oxides, borides, nitrides and carbides thereof.

3. Reflective optical element according to Claim 1 or 2, **characterized in that** the microstructured layer (58) comprises one or more materials of the group nickel-phosphorus, nickel-boron, copper, silver, gold, platinum, iridium, tantalum, titanium, zirconium, tungsten, molybdenum and niobium.

4. Reflective optical element according to any of Claims 1 to 3, **characterized in that** the functional layer (60) is arranged between the reflective coating (54) and the microstructured layer (58) and/or between the microstructured layer (58) and the substrate (51) and/or within the microstructured layer (58).

5. Reflective optical element according to any of Claims 1 to 4, **characterized in that** the polishing layer (52) comprises one or more materials of the group amorphous silicon, silicon dioxide, silicon nitride, gallium nitride and aluminium nitride.

6. Reflective optical element according to any of Claims 1 to 5, **characterized in that** the functional layer (60) is arranged between the polishing layer (52) and the reflective coating (54).

7. Reflective optical element according to any of Claims 1 to 6, **characterized in that** the substrate (51) comprises one or more of the materials of the group silicon, silicon carbide, silicon-infiltrated silicon carbide, quartz glass, titanium-doped quartz glass, glass, glass ceramic.

8. Reflective optical element according to any of Claims 1 to 7, **characterized in that** the reflective coating is configured as a multilayer system (54) comprising alternately arranged layers (56, 57) of a material having a lower real part of the refractive index at an operating wavelength in the wavelength range of between 5 nm and 20 nm and of a material having a higher real part of the refractive index at an operating wavelength in the wavelength range of between 5 nm and 20 nm.

9. Reflective optical element according to any of Claims 1 to 8, **characterized in that** it is configured as a collector mirror (13, 50).

10. Optical system for an EUV lithography apparatus having a reflective optical element according to any of Claims 1 to 9.

11. EUV lithography apparatus having an optical system according to Claim 10 or a reflective optical element according to any of Claims 1 to 9.

## Revendications

1. Élément optique réfléchissant destiné à la lithographie EUV, comprenant un substrat et un revêtement réfléchissant pour la réflexion d'un rayonnement dans la plage de longueurs d'onde de 5 nm à 20 nm, **caractérisé en ce qu'**entre le revêtement réfléchissant (54) et le substrat (51) sont disposées une couche fonctionnelle (60, 61), grâce à laquelle la concentration de l'hydrogène, en % en atomes, est sur la face du substrat dirigée vers le revêtement réfléchissant réduite d'au moins un facteur 2, et une couche microstructurée (58), et une couche de polissage (52) est disposée sur la couche fonctionnelle (60) ou sur la couche microstructurée (58), et sur le substrat est disposée une couche d'un promoteur d'adhérence (59) qui est constituée d'au moins une couche et comprend un ou plusieurs matériaux du groupe ruthénium, chrome, platine, iridium, cuivre, argent, or, nickel, nickel-phosphore, tantale, titane, zirconium, tungstène, molybdène et niobium.

2. Élément optique réfléchissant selon la revendication 1, **caractérisé en ce que** la couche fonctionnelle (60, 61) comprend un ou plusieurs des matériaux du groupe étain, argent, molybdène, ruthénium, iridium, nickel, fer, cobalt, cuivre, aluminium, platine, zinc, manganèse, plomb, or, palladium, tungstène, tantale, leurs alliages, oxydes, borures, nitrures et carbures.

3. Élément optique réfléchissant selon la revendication 1 ou 2, **caractérisé en ce que** la couche microstructurée (58) comprend un ou plusieurs matériaux du groupe nickel-phosphore, nickel-bore, cuivre, argent, or, platine, iridium, tantale, titane, zirconium, tungstène, molybdène et niobium.

4. Élément optique réfléchissant selon l'une des revendications 1 à 3, **caractérisé en ce que** la couche fonctionnelle (60) est disposée entre le revêtement réfléchissant (54) et la couche microstructurée (58) et/ou entre la couche microstructurée (58) et le substrat (51) et/ou à l'intérieur de la couche microstructurée (58).

5. Élément optique réfléchissant selon l'une des revendications 1 à 4, **caractérisé en ce que** la couche de polissage (52) comprend un ou plusieurs matériaux du groupe silicium amorphe, dioxyde de silicium, nitrure de silicium, nitrure de gallium et nitrure d'aluminium.

6. Élément optique réfléchissant selon l'une des revendications 1 à 5, **caractérisé en ce que** la couche fonctionnelle (60) est disposée entre la couche de polissage (52) et le revêtement réfléchissant (54).

7. Élément optique réfléchissant selon l'une des revendications 1 à 6, **caractérisé en ce que** le substrat (51) comprend un ou plusieurs des matériaux du groupe silicium, carbure de silicium, carbure de silicium à infiltration de silicium, verre quartzeux, verre quartzeux dopé au titane, verre, vitrocéramique.

8. Élément optique réfléchissant selon l'une des revendications 1 à 7, **caractérisé en ce que** le revêtement réfléchissant est conçu comme un système multicouche (54), qui comprend des couches (56, 57) disposées en alternance d'un matériau ayant une faible valeur réelle de l'indice de réfraction pour une longueur d'onde de travail dans la plage de longueurs d'onde entre 5 nm et 20 nm et d'un matériau ayant une partie réelle élevée de l'indice de réfraction pour une longueur d'onde de travail dans la plage de longueurs d'onde entre 5 nm et 20 nm.

9. Élément optique réfléchissant selon l'une des revendications 1 à 8, **caractérisé en ce qu'**il est conçu comme un miroir collecteur (13, 50).

10. Système optique destiné à un dispositif de lithographie EUV, comportant un élément optique réfléchissant selon l'une des revendications 1 à 9.

11. Dispositif de lithographie EUV comportant un système optique selon la revendication 10 ou un élément optique réfléchissant selon l'une des revendications 1 à 9.
